# FASCICULE DE BREVET EUROPEEN

(11) **EP 2 922 062 B1**
(45) Date de publication et mention de la délivrance du brevet: **13.07.2016**
(21) Numéro de dépôt: 15159141.9
(22) Date de dépôt: 16.03.2015
(51) Int. Cl.: H01L 27/11, G11C 11/412, G11C 14/00

(54) **Dispositif de mémoire associant un plan mémoire du type SRAM et un plan-mémoire du type non volatil, durci contre des basculements accidentels**
Speichervorrichtung, die eine Speicherebene vom SRAM-Typ mit einer Speicherebene vom nicht-flüchtigen Typ kombiniert und gegen zufälliges Umkippen gehärtet ist
Memory device including a SRAM memory plane and a non volatile memory plane, rugged against soft errors

(30) Priorité: 21.03.2014 FR 1452362
(43) Date de publication de la demande: 23.09.2015
(73) Titulaire: STMicroelectronics (Rousset) SAS, 13790 Rousset (FR)
(72) Inventeur: Tailliet, François, 13710 Fuveau (FR); Battista, Marc, 13013 Marseille (FR)
(74) Mandataire: Casalonga

(56) Documents cités:
- EP-A2- 0 357 980
- WO-A1-95/27982
- FR-A1- 2 499 769
- US-A1- 2009 190 402

## Description

Des modes de réalisation de l'invention concernent les dispositifs de mémoire, notamment ceux associant, au sein d'une même cellule-mémoire, une cellule élémentaire du type mémoire vive statique (SRAM : Static Random Access Memory) et une ou plusieurs cellules-mémoire élémentaires non volatiles, par exemple deux ou quatre, en particulier des cellules-mémoire élémentaires du type mémoire morte électriquement effaçable et programmable (EEPROM : Electrically-Erasable and Programmable Read-Only Memory), à double grille.

L'invention concerne plus particulièrement le durcissement d'une telle cellule-mémoire contre les basculements accidentels de la mémoire de type SRAM.

Une cellule-mémoire élémentaire du type SRAM est une cellule-mémoire volatile, c'est-à-dire perdant ses données en cas de coupure d'alimentation, mais offrant une rapidité d'accès très rapide ainsi qu'un cyclage infini.

Une cellule-mémoire élémentaire non volatile, par exemple une cellule-mémoire du type EEPROM, permet de conserver la donnée en cas de coupure d'alimentation mais ne peut pas être cyclée indéfiniment.

Une cellule-mémoire associant une cellule élémentaire du type SRAM et une ou plusieurs cellules non volatiles (par exemple deux ou quatre) permet de cumuler les performances des deux approches, à savoir la vitesse et l'endurance infinie de la mémoire SRAM et la non-volatilité de la mémoire non volatile, par exemple la mémoire flash ou EEPROM.

Dans des conditions normales de fonctionnement, l'écriture et la lecture d'une donnée dans une telle cellule-mémoire s'effectuent dans la cellule élémentaire du type SRAM. Par contre, notamment lors d'une coupure d'alimentation, il y a transfert du contenu de la cellule élémentaire SRAM dans la ou les cellules-mémoire élémentaires non volatiles qui lui sont associées.

Puis, lors d'une remontée d'alimentation notamment, il y a rechargement des données contenues dans les cellules-mémoire non volatiles, dans la cellule-mémoire élémentaire SRAM correspondante.

Des exemples d'architectures de telles cellules-mémoire associant mémoire SRAM et mémoire non volatile sont décrites dans les documents US 4,132,905, US 4,467,451, US 4,980,859, US 7,164,608, US 8,018,768 et dans les demandes de brevets français déposées sous les n° 1355439, 1355440 et 1356720.

Dans la cellule élémentaire de type SRAM, il existe un risque de basculement accidentel des bits, c'est-à-dire une inversion de la valeur logique de la donnée stockée dans la mémoire SRAM au niveau de la bascule formée par les deux inverseurs de cette mémoire. En d'autres termes, si à un instant donné, un niveau logique bas est présent à la sortie de l'un des inverseurs et un niveau logique haut est présent à la sortie de l'autre inverseur, un basculement se traduit par un remplacement du niveau logique haut par le niveau logique bas et inversement, ce qui se traduit par une inversion de la donnée stockée.

Ces erreurs de basculement, encore dénommées par l'homme du métier sont la dénomination anglo-saxonne de « soft errors », peuvent être provoquées par des perturbations causées par des particules telles que des particules alpha ou bien des rayons cosmiques, ou encore par des attaques du dispositif de mémoire par un rayonnement laser.

Un exemple de cellule-mémoire SRAM comprenant des condensateurs permettant de limiter ces erreurs est décrit dans le document EP 0 357 980 A2. Un exemple de structure combinant un condensateur et un transistor MOS est décrit dans le document FR 2 499 769 A1.

Une solution actuellement utilisée pour lutter contre ces erreurs de basculement consiste à utiliser des codes correcteurs d'erreurs et à éloigner physiquement des bits appartenant à un même groupe de correction d'erreurs.

L'invention est définie dans les revendications 1 à 10. Selon un mode de réalisation, il est proposé une solution totalement différente et plus simple pour limiter le risque de basculement accidentel de bits de la cellule SRAM.

Selon un mode de réalisation, il est ainsi proposé d'utiliser, au sein de la cellule SRAM, au moins une structure intégrée comportant un transistor MOS ayant un premier diélectrique de grille et un condensateur ayant une première électrode formée par la région de grille du transistor et une deuxième électrode située au dessus de la première électrode et séparée de la première électrode par un deuxième diélectrique de grille situé au dessus du premier diélectrique de grille, une première région de contact électriquement conductrice au contact de la région de grille et une deuxième région de contact électriquement conductrice au contact de la deuxième électrode, les deux régions de contact n'étant pas électriquement reliées.

Ainsi dans cette structure, le deuxième diélectrique de grille ne se situe pas au même niveau, par rapport à la région de canal du transistor, que celui du premier diélectrique de grille mais à un niveau de rang supérieur.

De même la deuxième électrode ne se situe pas au même niveau, par rapport à la région de canal du transistor, que celui de la première électrode mais à un niveau de rang supérieur.

Une telle structure, compacte en terme d'encombrement, puisque la première électrode du condensateur est formée par la région de grille du transistor, permet de réaliser de façon simple, une capacité de filtrage au sein de la cellule SRAM, de valeur généralement bien plus élevée que les capacités réalisées au premier niveau de métallisation du circuit intégré, mieux contrôlée et n'induisant pas de couplage avec les interconnexions situées au-dessus de la cellule SRAM.

Cette capacité de filtrage accroît ainsi fortement l'énergie nécessaire pour basculer accidentellement la bascule formée par les deux inverseurs de la cellule SRAM.

Ainsi, selon un aspect, il est proposé un dispositif de mémoire comprenant au moins une cellule-mémoire du type comportant une cellule-mémoire élémentaire du type SRAM possédant deux inverseurs couplés de façon croisée et au moins une cellule-mémoire élémentaire non volatile mutuellement couplées.

Selon une caractéristique générale de cet aspect, ladite au moins une cellule-mémoire élémentaire non volatile comporte au moins un transistor à grille flottante, la cellule-mémoire élémentaire du type SRAM comporte au moins deux structures intégrées telles que définies ci-avant dont les transistors MOS forment respectivement au moins deux transistors des deux inverseurs, par exemple les transistors PMOS ; chaque deuxième électrode est destinée à être reliée à un potentiel, par exemple le potentiel du noeud de sortie de l'inverseur ou bien une tension d'alimentation ou bien la masse ; les autres transistors de la cellule-mémoire élémentaire SRAM comportent une région de grille surmontée par une région auxiliaire située au même niveau que les deuxième électrodes des structures intégrées et séparées de la région de grille par le deuxième diélectrique de grille.

Ainsi, lorsque le ou les transistors de la cellule-mémoire élémentaire non volatile sont un ou des transistors à grille flottante, comportant de ce fait deux niveaux de polysilicium par exemple, on réalise avantageusement tous les transistors de la cellule SRAM avec ces deux niveaux de poly-silicium et on utilise avantageusement ces deux niveaux de polysilicium existants pour réaliser sur au moins deux transistors des deux inverseurs, par exemple les transistors PMOS, lesdites structures intégrées évoquées ci-avant dont le condensateur est formé entre les deux niveaux de polysilicium. Et, pour les autres transistors de la cellule SRAM pour lesquels on ne souhaite pas former de condensateur, on ne connectera électriquement que le polysilicium inférieur ou bien on court-circuitera les deux niveaux de polysilicium.

Le deuxième diélectrique de grille qui sépare les deux électrodes du condensateur comprend avantageusement une couche de nitrure de silicium prise en sandwich entre deux couches de dioxyde de silicium. Une telle composition permet d'obtenir un condensateur ayant une valeur capacitive bien contrôlée, typiquement de l'ordre de 3fF/µm².

Ces condensateurs additionnels augmentent par ailleurs la valeur capacitive entre l'alimentation et la masse du plan mémoire SRAM et forment par conséquent une capacité de découplage améliorant l'immunité au bruit.

Chaque cellule-mémoire élémentaire non volatile peut être une cellule du type mémoire morte électriquement effaçable et programmable (EEPROM).

Par ailleurs, le dispositif de mémoire peut comprendre un plan mémoire comportant des lignes et des colonnes de cellules-mémoire.

Selon un autre aspect, il est proposé un circuit intégré incorporant un dispositif de mémoire tel que défini ci-avant.

D'autres avantages et caractéristiques de l'invention apparaîtront à l'examen de la description détaillée de modes de réalisation, nullement limitatifs, et des dessins annexés sur lesquels :
- la figure 1 illustre schématiquement une cellule-mémoire de l'art antérieur,
- les figures 2 à 15 illustrent schématiquement différents modes de réalisation de l'invention.

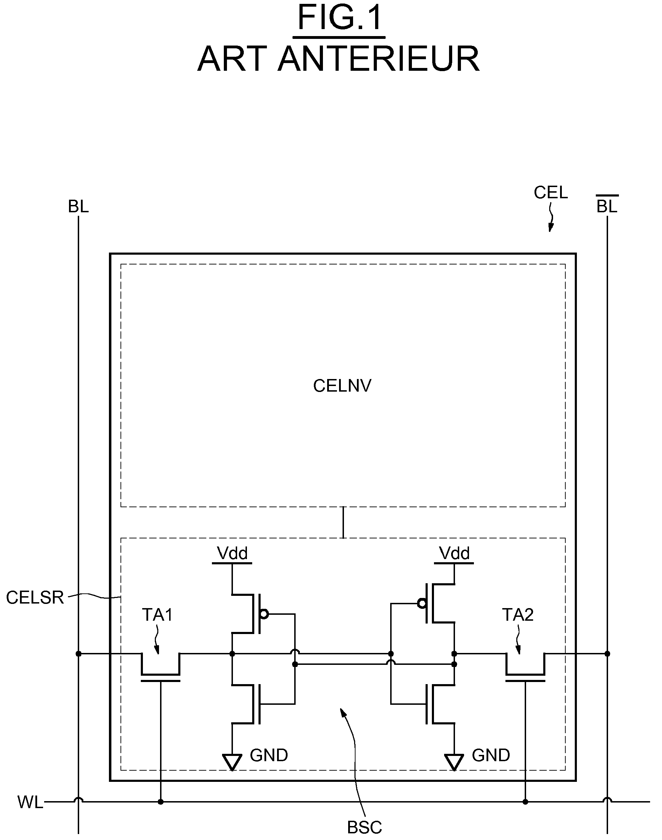

Sur la figure 1, la référence CEL désigne une cellule-mémoire d'un plan mémoire, comportant une cellule-mémoire élémentaire du type SRAM CELSR et au moins une cellule-mémoire élémentaire non volatile CELNV, ces deux cellules-mémoire élémentaires étant mutuellement couplées.

La cellule-mémoire élémentaire CELSR est de structure classique et comprend une bascule BSC formée de deux inverseurs CMOS connectés de façon croisée, ainsi que deux transistors d'accès TA1 et TA2.

Les deux inverseurs sont connectés entre une borne d'alimentation destinée à être connectée à la tension d'alimentation Vdd, et la masse GND.

Les deux transistors d'accès TA1 et TA2 sont respectivement connectés entre les sorties des deux inverseurs et deux lignes de bits BL et *B̅L̅, B̅L̅* désignant la ligne de bits complémentée de la ligne BL.

Les grilles des transistors d'accès TA1 et TA2 sont connectées sur une ligne de mots WL.

L'écriture et la lecture d'une donnée dans la cellule-mémoire élémentaire CELSR sont des opérations classiques et connues en soi.

Lors d'une coupure d'alimentation ou sur commande externe, la donnée contenue dans la cellule-mémoire élémentaire CELSR est transférée et stockée dans la cellule-mémoire élémentaire non volatile CELNV. Il s'agit d'un « transfert non volatil ». Puis, lors d'une remontée d'alimentation, la cellule-mémoire élémentaire CELSR est rechargée avec le contenu de la cellule-mémoire élémentaire non volatile CELNV.

Et, selon les configurations choisies lors de cette opération de rechargement de la cellule CELSR, la donnée peut ou non être inversée par rapport à celle qui était initialement stockée dans la cellule-mémoire CELSR avant le transfert non volatil vers la cellule-mémoire élémentaire non volatile CELNV.

Comme indiqué ci-avant, une telle cellule-mémoire élémentaire SRAM CELSR peut présenter des risques de basculement des états logiques présents aux noeuds de sortie des deux inverseurs, par exemple en présence de rayons cosmiques ou encore lors d'une attaque par faisceau laser.

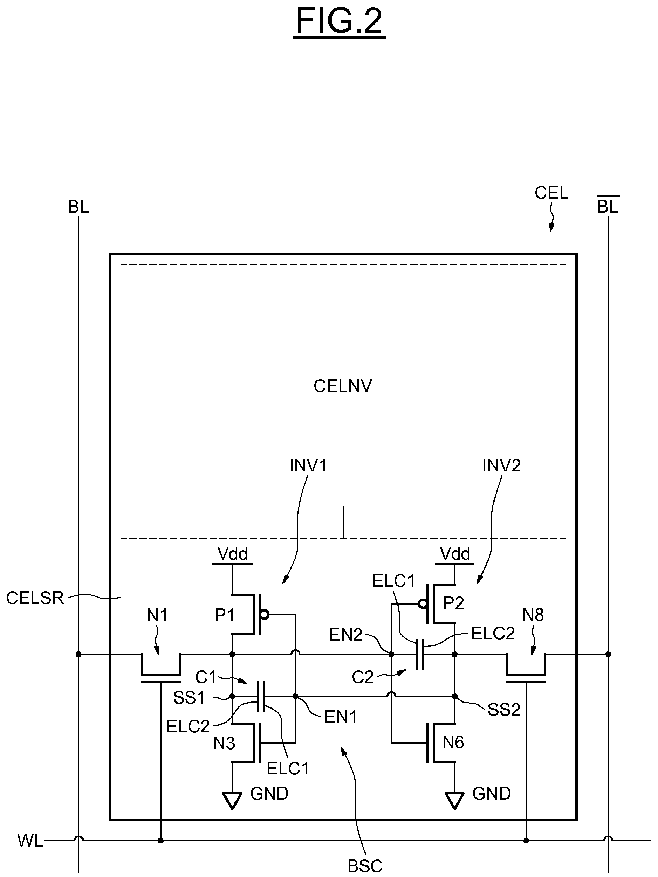

La cellule-mémoire élémentaire CELSR de la cellule de la figure 2 est configurée pour réduire ce risque de basculement accidentel.

A cet égard, la cellule CELSR comporte un premier condensateur C1 dont une première électrode ELC1 est connectée à l'entrée EN1 et dont une deuxième électrode ELC2 est connectée à la sortie SS1 du premier inverseur INV1 de la bascule BSC, ce premier inverseur INV1 comportant le transistor PMOS P1 et le transistor NMOS N3.

De même, un deuxième condensateur C2 est connecté entre l'entrée EN2 et la sortie SS2 du deuxième inverseur INV2 de la bascule BSC, comportant le transistor PMOS P2 et le transistor NMOS N6.

Dans ce mode de réalisation, les deux transistors d'accès de la cellule CELSR sont référencés N1 et N8.

Ces deux condensateurs C1 et C2 permettent d'augmenter la capacité totale de la bascule BSC ce qui accroît l'énergie nécessaire pour faire basculer accidentellement la bascule BSC.

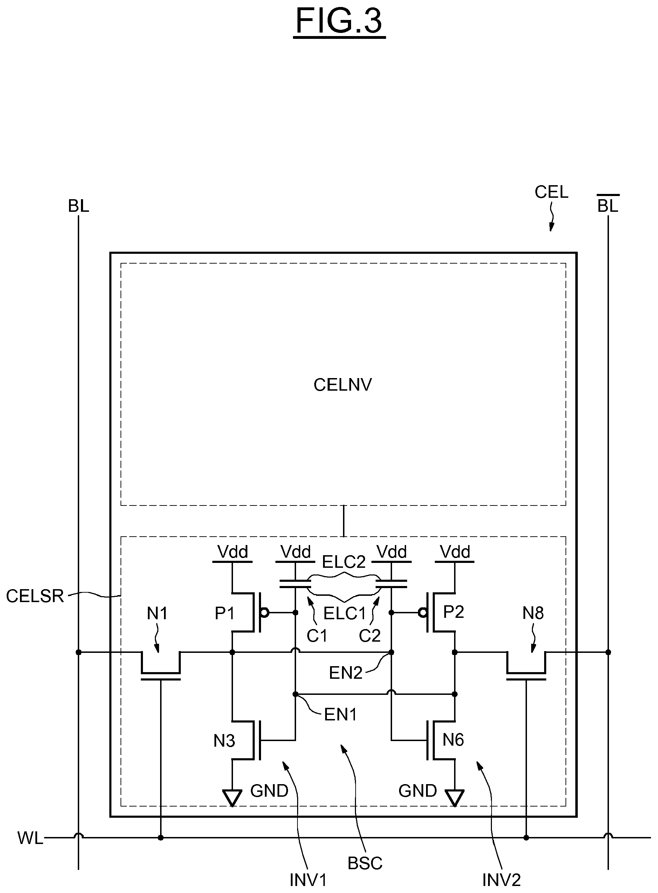

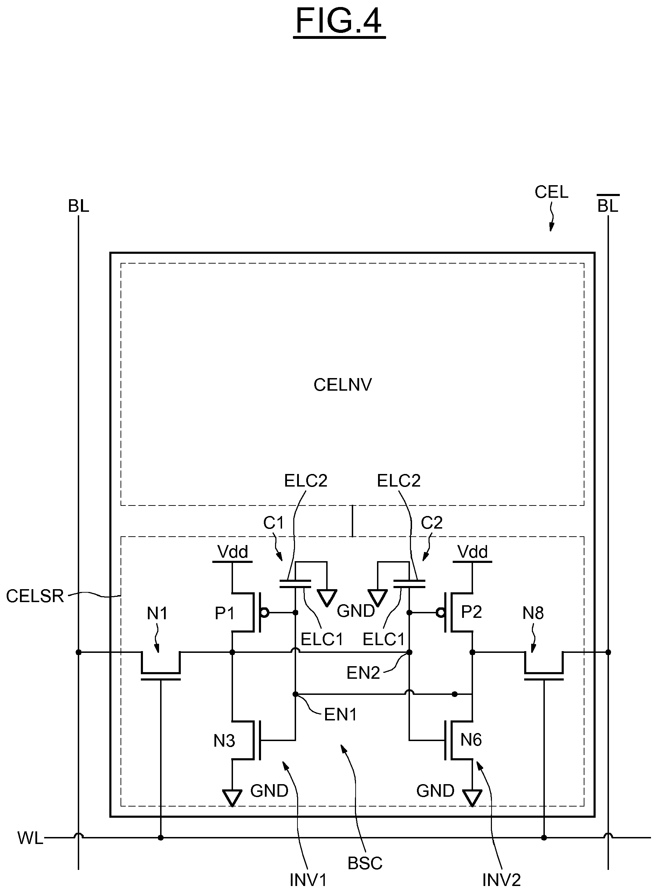

Alors que dans le mode de réalisation de la figure 2, chaque condensateur est connecté entre l'entrée et la sortie de l'inverseur correspondant, il est possible, comme illustré sur la figure 3, de connecter la deuxième électrode de chaque condensateur C1, C2 à un potentiel fixe, par exemple la tension d'alimentation Vdd, ou bien, comme illustré sur la figure 4 la masse GND.

Le fait de connecter chaque condensateur entre l'entrée et la sortie de l'inverseur correspondant (figure 2) permet, par rapport aux connexions à la tension d'alimentation (figure 3) ou à la masse (figure 4), d'augmenter plus fortement la quantité d'énergie à injecter pour faire basculer la bascule car, lors d'un basculement, le potentiel de l'une des électrodes du condensateur monte tandis que le potentiel de l'autre électrode descend ce qui double l'excursion de tension nécessaire au basculement. Par contre, puisque ce basculement est alors plus lent, le rechargement de la cellule CELSR (transfert de la donnée de la cellule non volatile vers la cellule SRAM) est plus lent. Mais, ceci n'est pas une contrainte dans de telles cellules qui acceptent des temps d'écriture de quelles dizaines de nano-secondes.

Le fait de relier chaque condensateur à un potentiel fixe (la tension d'alimentation Vdd ou la masse comme illustré sur les figures 3 et 4) permet d'éviter toute influence du noeud d'entrée d'un inverseur sur son noeud de sortie, ce qui permet un meilleur rechargement non volatil de la cellule CELSR.

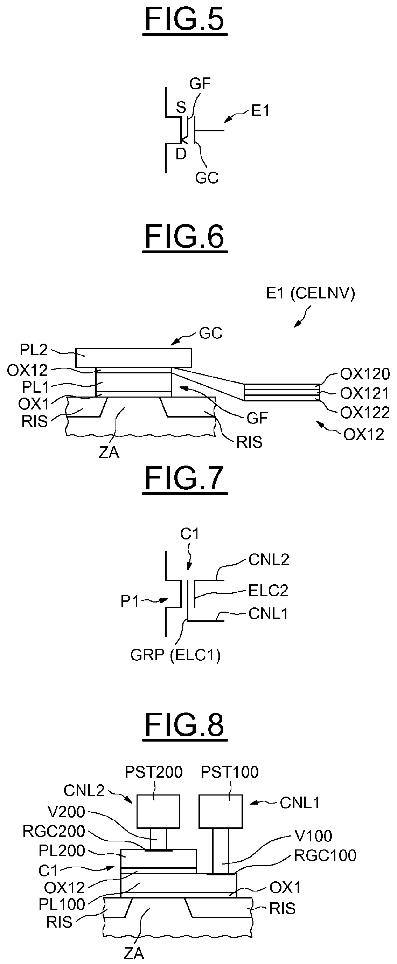

Une façon simple de réaliser les condensateurs C1 et C2 va maintenant être décrite en se référant plus particulièrement aux figures 5 à 10.

Comme illustré sur les figures 5 et 6, la ou les cellules-mémoire non volatiles CELNV comportent un ou des transistors à grille flottante E1. Plus précisément, le transistor E1 comporte comme illustré sur la figure 5, une grille flottante GF surmontée par une grille de commande GC.

Comme illustré sur la figure 6, la grille flottante comporte une première région de grille PL1, ici en polysilicium, séparée de la région sous jacente de canal, située dans une zone active ZA du substrat, par un oxyde de grille OX1, par exemple du dioxyde de silicium ayant typiquement une épaisseur comprise entre 20Å et 250Å. La zone active ZA est limitée de façon classique par une région isolante RIS, par exemple du type tranchée peu profonde (STI : « Shallow Trench Isolation »)

La grille de commande GC comporte également une région de grille PL2, ici également en polysilicium, séparée de la région de grille PAL1 par un diélectrique de grille OX12. Ce diélectrique de grille OX12 comporte avantageusement une couche de nitrure de silicium OX121 (Si₃N₄) prise en sandwich entre deux couches de dioxyde de silicium OX120, OX122 (SiO₂). L'épaisseur du diélectrique de grille OX12 est typiquement comprise en 100Å et 200Å.

Tous les transistors de la cellule-mémoire CEL, et en particulier tous les transistors de la cellule-mémoire élémentaire de type SRAM CELSR, sont également réalisés avec un double niveau de grilles, la géométrie des régions de grille étant toutefois différente de celle des régions de grille des transistors à grille flottante.

Et, on va avantageusement utiliser ce double niveau de région de grille pour former les condensateurs C1 et C2.

Ceci est illustré schématiquement sur les figures 7 et 8, en ce qui concerne, dans ce mode de réalisation, les transistors PMOS P1 et P2 des deux inverseurs de la bascule BSC de la cellule-mémoire élémentaire CELSR. A des fins de simplification des figures, on n'a représenté sur les figures 7 et 8 que le transistor PMOS P1

La région de grille PL100, ici en polysilicium, séparée de la partie sous jacente de la zone active ZA (limitée par une région isolante RIS) par l'oxyde de grille OX1 définit la grille GRP du transistor P1 mais également une première électrode ELC1 du condensateur C1.

La deuxième région PL200 également ici en polysilicium, séparée de la première région PL100 par le diélectrique de grille OX12 définit une deuxième électrode ELC2 pour le condensateur C1.

Une première connexion électrique CNL1 vient au contact d'une région de contact électriquement conductrice RGC100 (par exemple un siliciure de métal) de la grille GRP et comporte, dans ce mode de réalisation, un contact V100 et une portion de piste métallique PST100, située au premier niveau de métallisation du circuit intégré.

Une deuxième connexion électrique CNL2 vient au contact d'une région de contact électriquement conductrice RCG200 (par exemple un siliciure de métal) de la deuxième électrode PL200 (ELC2) et comporte ici également un contact V200 et une portion de piste métallique PST200, également située au premier niveau de métallisation du circuit intégré.

Cette connexion électrique CNL2 permet de relier la deuxième électrode PL200 à un potentiel qui peut être comme indiqué ci-avant, le potentiel d'un noeud de sortie de l'inverseur correspondant ou bien un potentiel fixe tel que la tension d'alimentation ou bien la masse.

Les deux connexions électriques CNL1 et CNL2 ne sont pas reliées ensemble.

On a donc réalisé ici très simplement une structure compacte comportant un transistor MOS dont la grille est connectée avec un condensateur.

Dans le mode de réalisation qui vient d'être décrit, seuls les transistors PMOS des deux inverseurs sont équipés d'un condensateur connecté sur leur grille. En effet, dans ce mode de réalisation, étant donné que la distance drain/source d'un transistor NMOS est plus courte que la distance drain/source d'un transistor PMOS, il s'avère plus difficile d'équiper également les transistors NMOS des deux inverseurs d'un condensateur d'une façon analogue à ce qui a été décrit en référence aux figures 7 et 8, tout en respectant les règles de conception (DRM : « Design Rules Manual »).

Bien entendu il serait possible dans d'autres modes de réalisation que seuls les transistors NMOS des deux inverseurs soient équipés d'un condensateur connecté sur leur grille ou bien que tous les transistors PMOS et NMOS des deux inverseurs soient équipés d'un condensateur connecté sur leur grille.

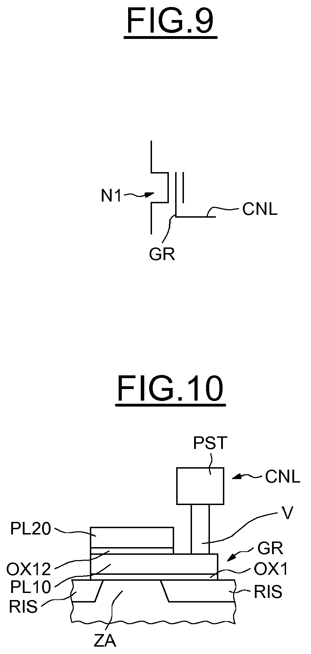

En ce qui concerne les autres transistors de la cellule SRAM, notamment les transistors d'accès N1, N8 mais également les transistors NMOS, N3 et N6, on voit sur les figures 9 et 10, que la deuxième région de polysilicium PL20, séparée de la première région de polysilicium PL10 par le diélectrique de grille OX12 est laissée flottante. La première région de polysilicium PL10, séparée de la zone sous-jacente de zone active ZA (limitée par une région isolante RIS) par l'oxyde de grille OX1, forme la grille GR du transistor correspondant, ici le transistor N1. Une connexion électrique CNL, comportant un contact V et une portion de piste métallique PST située au niveau de métallisation M1 permet d'applique une tension de commande sur la grille GR.

En variante, au lieu de laisser la deuxième région de grille PL20 flottante, il serait possible de la court-circuiter avec la première région de grille PL10.

L'invention s'applique à tous types de cellules-mémoire non volatiles ayant un ou plusieurs transistors à grille flottante, comme par exemple des cellules EEPROM.

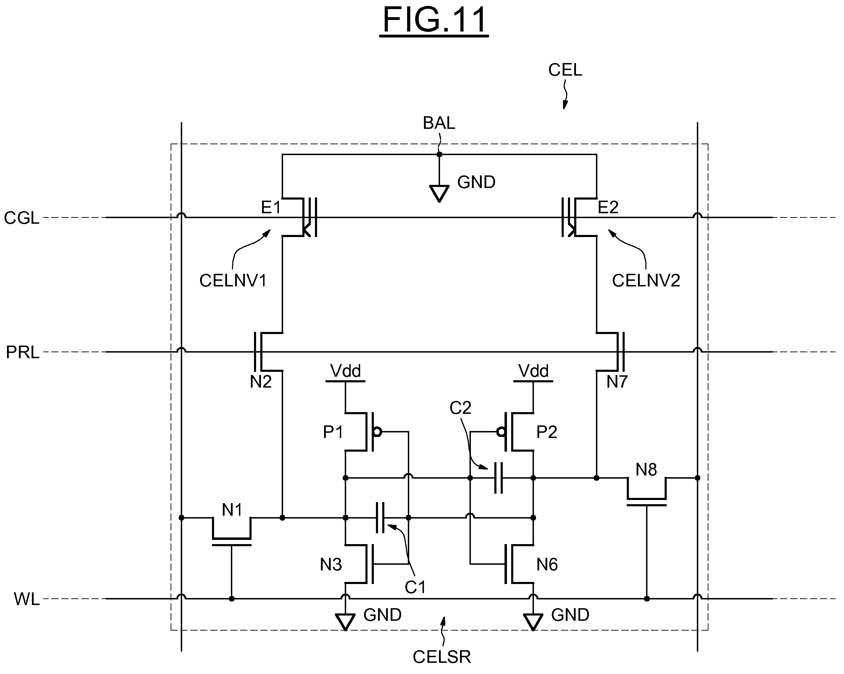

La figure 11 illustre un exemple de réalisation d'une cellule-mémoire SEL comportant la cellule-mémoire élémentaire du type SRAM CELSR et deux cellules élémentaires non volatiles du type EEPROM CELNV1 et CELNV2 comportant ici deux transistors à grille flottante E1 et E2.

Une telle cellule a été décrite dans la demande de brevet français n° 1356720. On en rappelle maintenant certaines caractéristiques.

Les cellules non volatiles EEPROM de la cellule CEL sont des cellules classiques c'est-à-dire dans lesquelles on a retiré le transistor de sélection et présentant une zone d'injection tunnel entre grille flottante et drain.

Les sources de ces deux transistors E1 et E2 sont reliées à une borne d'alimentation BAL qui est ici reliée à la masse.

Les électrodes de commande des deux transistors à grille flottante E1 et E2 sont quant à elles connectées sur une première ligne de commande CGL.

Les drains des deux transistors à grille flottante E1 et E2 sont connectés aux entrées et aux sorties des deux inverseurs de la cellule CELSR par un étage d'interconnexion comportant ici deux transistors d'interconnexion NMOS référencés N2 et N7.

Plus précisément, les deux transistors d'interconnexion N2 et N7 sont respectivement connectés entre les drains des deux transistors à grille flottante E1 et E2 et les deux sorties des deux inverseurs P1, N3 et P2, N6. Par ailleurs, les électrodes de commande (grilles) de ces deux transistors d'interconnexion N2 et N7 sont connectées sur une deuxième ligne de commande PRL.

Lors de l'écriture dans la cellule-mémoire élémentaire CELSR, qui est une écriture classique, la ligne de commande PRL est à la masse rendant bloqué l'étage d'interconnexion. De même, la première ligne de commande CGL est également à la masse.

Comme il est bien connu par l'homme du métier, un transfert ou écriture non volatil se compose d'un cycle d'effacement suivi d'un cycle de programmation différentiel puisqu'on est en présence de deux cellules-mémoire élémentaires non volatiles.

Pour le cycle d'effacement, la ligne PRL est maintenue à la masse rendant bloqués les transistors d'interconnexion N2 et N7. On envoie ensuite une tension d'effacement sur la première ligne de commande CGL.

Pendant le cycle de programmation différentielle, la deuxième ligne de commande PRL passe à la tension d'alimentation rendant passants les transistors N2 et N7. On envoie ensuite une tension de programmation pour la première ligne de commande CGL.

Pour un rechargement de la cellule CELSR, la première ligne de commande CGL passe à une tension de référence de lecture, typiquement 1 volt, tandis que la deuxième ligne de commande PRL est à une tension de 2 volts par exemple de façon à rendre passants les transistors N2 et N7.

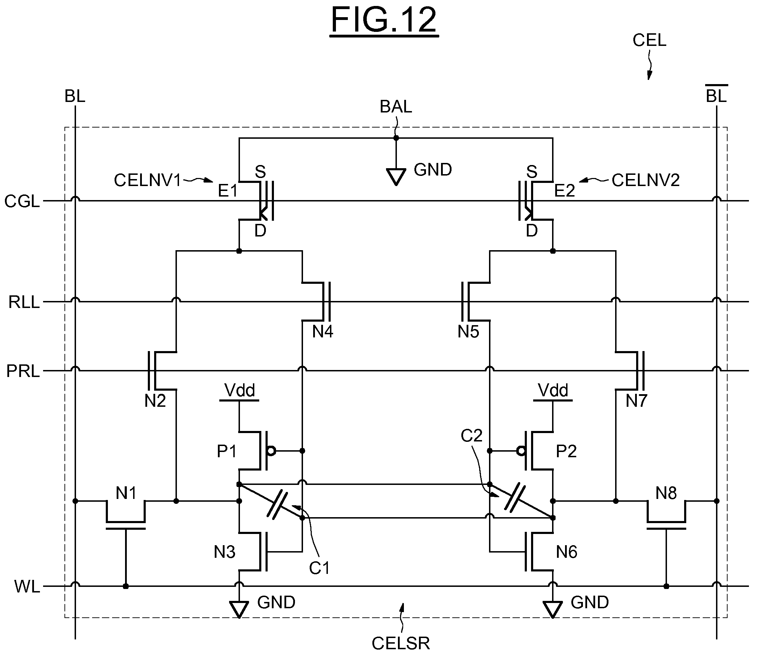

La figure 12 illustre un autre mode de réalisation d'une cellule-mémoire CEL incorporant là encore deux cellules-mémoire non volatiles du type EEPROM CELNV1 et CELNV2 comportant ici deux transistors à grille flottante E1 et E2.

Une telle cellule a été décrite dans la demande de brevet n° 1355439. On en rappelle ici certaines caractéristiques.

Là encore, les cellules non volatiles EEPROM de la cellule CEL sont des cellules classiques c'est-à-dire dans lesquelles on a retiré le transistor de sélection et présentant une zone d'injection tunnel entre grille flottante et drain.

Les sources de ces deux transistors E1 et E2 sont reliées à une borne d'alimentation BAL qui est ici reliée à la masse.

Les électrodes de commande des deux transistors à grille flottante E1 et E2 sont quant à elles connectées sur une première ligne de commande CGL.

Les drains des deux transistors à grille flottante E1 et E2 sont connectés aux entrées et aux sorties des deux inverseurs par un étage d'interconnexion comportant ici deux premiers transistors d'interconnexion NMOS référencés N2 et N7 et deux deuxièmes transistors d'interconnexion NMOS référencés N4 et N5.

Plus précisément, les deux premiers transistors d'interconnexion N2 et N7 sont respectivement connectés entre les drains des deux transistors à grille flottante E1 et E2 et les deux sorties des deux inverseurs P1, N3 et P2, N6. Par ailleurs, les électrodes de commande (grilles) de ces deux transistors d'interconnexion N2 et N7 sont connectées sur une deuxième ligne de commande PRL.

Les deux deuxièmes transistors d'interconnexion N4 et N5 sont quant à eux respectivement connectés entre les drains des deux transistors à grille flottante E1 et E2 et les deux entrées de deux inverseurs P1, N3 et P2, N6.

Les électrodes de commande de ces deux deuxièmes transistors d'interconnexion N4 et N5 sont connectées sur une troisième ligne de commande RLL.

Bien que les deux deuxièmes transistors d'interconnexion N4 et N5 ne soient pas indispensables, ils sont particulièrement avantageux car ils permettent d'éviter une inversion de données lors du rechargement du contenu des deux cellules non volatiles E1 et E2 vers la cellule-mémoire élémentaire SRAM CELSR et ce, même avec une borne d'alimentation BAL reliée à la masse.

L'écriture dans la cellule mémoire élémentaire CELSR est une écriture classique.

Les lignes de commande PRL, RLL sont à cet égard à la masse, rendant bloqué l'étage d'interconnexion. De même, la première ligne de commande CGL est également à la masse.

La lecture d'une donnée dans la cellule CELSR est également une lecture classique.

Pour le cycle d'effacement, les lignes PRL et PLL sont maintenues à la masse, rendant bloqués les transistors d'interconnexion N2, N4, N5 et N7. On envoie ensuite une tension d'effacement sur la première ligne de commande CGL.

Pour le cycle de programmation différentielle, la deuxième ligne de commande PRL passe à la tension d'alimentation Vdd tandis que la troisième ligne de commande RLL reste à la masse.

De ce fait, les transistors d'interconnexion N2 et N7 sont passants tandis que les transistors d'interconnexion N4 et N5 sont bloqués.

On envoie ensuite une tension de programmation sur la première ligne de commande CGL.

Les transistors à grille flottante E1 et E2 sont tous bloqués lors de cette programmation différentielle.

Pour un rechargement de la cellule CELSR, la première ligne de commande CGL passe à une tension de référence de lecture, typiquement 1 volt, tandis que la deuxième ligne de commande PRL est à la masse et que la troisième ligne de commande RLL est à une tension de 2 volts par exemple de façon à rendre passants les transistors N4 et N5 tandis que les transistors N2 et N7 sont bloqués.

La tension de la ligne de mots WL est nulle.

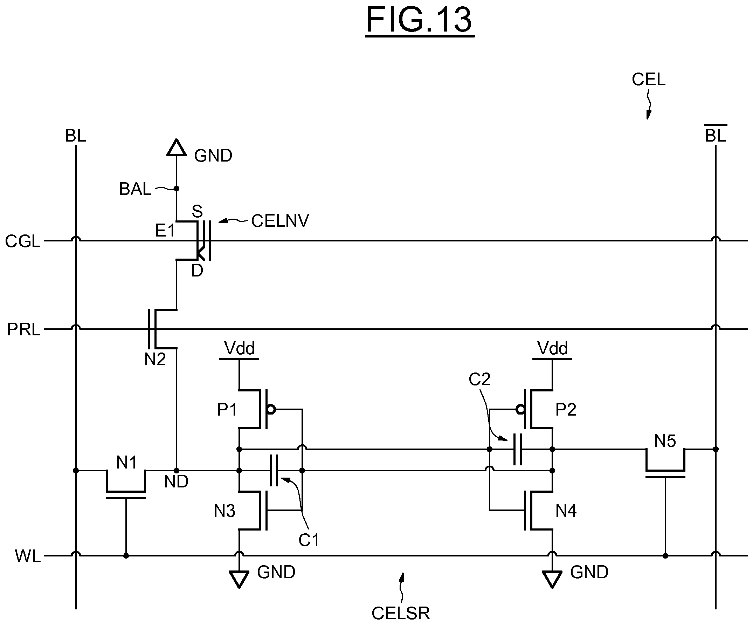

La figure 13 illustre encore un autre mode de réalisation d'une cellule-mémoire CEL.

Une telle cellule a été décrite sur la demande de brevet français précité n° 1355440.

On en rappelle ici certaines caractéristiques.

Cette cellule-mémoire CEL comporte une unique cellule élémentaire non volatile du type EEPROM CELNV comportant ici un transistor à grille flottante E1 commandable de façon à être bloqué lors d'une programmation dans la cellule-mémoire élémentaire non volatile, d'une donnée stockée dans la cellule-mémoire élémentaire du type SRAM.

Là encore, la cellule non volatile EEPROM de la cellule CEL est une cellule classique c'est-à-dire dans laquelle on a retiré le transistor de sélection et présentant une zone d'injection tunnel entre grille flottante et drain.

La source du transistor E1 est reliée à une borne d'alimentation BAL qui est ici reliée à la masse.

L'électrode de commande du transistor à grille flottante E1 est quant à elle connectée sur une première ligne de commande CGL.

Le drain du transistor à grille flottante E1 est connecté ici à la sortie (noeud ND) du premier inverseur P1, N3 de la cellule-mémoire élémentaire CELSR par l'intermédiaire d'un étage d'interconnexion comportant ici un premier transistor d'interconnexion N2. Cet unique transistor d'interconnexion N2 est ici un transistor NMOS.

L'électrode de commande (grille) de ce premier transistor d'interconnexion N2 est connectée sur une deuxième ligne de commande PRL. De ce fait l'étage d'interconnexion est commandé par un signal externe à la cellule-mémoire CEL, à savoir par la tension de commande présente sur la deuxième ligne de commande PRL.

L'écriture dans la cellule mémoire élémentaire CELSR est là encore une écriture classique.

La ligne de commande PRL est à cet égard à la masse, rendant bloqué l'étage d'interconnexion. De même, la première ligne de commande CGL est également à la masse.

Pour le cycle d'effacement, la ligne PRL est maintenue à la masse, rendant bloqué le transistor d'interconnexion N2. On envoie ensuite une tension d'effacement sur la première ligne de commande CGL.

Pour le cycle de programmation la deuxième ligne de commande PRL passe à la tension d'alimentation Vdd

De ce fait, le transistor d'interconnexion N2 est passant.

On envoie ensuite une tension de programmation sur la première ligne de commande CGL.

Préalablement à un rechargement, on effectue une initialisation (ou une réinitialisation) de la cellule-mémoire élémentaire SRAM CELSR de façon à l'initialiser dans un état connu et éviter qu'elle soit dans un état métastable.

Cette initialisation peut s'effectuer par exemple par écriture d'un « 1 » dans la cellule SRAM en utilisant la procédure d'écriture classique.

Pour le rechargement, la première ligne de commande CGL passe à une tension de référence de lecture, typiquement 1 volt, tandis que la deuxième ligne de commande PRL est à une tension de 2 volts par exemple de façon à rendre passant le transistor d'interconnexion N2.

La tension de la ligne de mots WL est nulle.

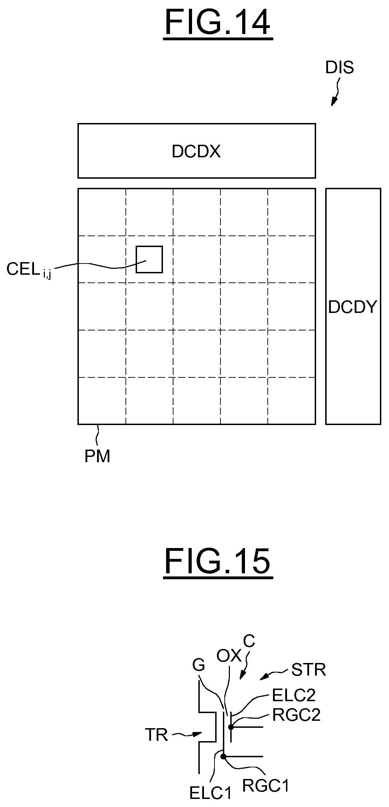

Bien entendu, comme illustré schématiquement sur la figure 14, le dispositif de mémoire DIS peut comporter en pratique un plan mémoire PM comportant une matrice de cellules CELij organisées en lignes et en colonnes, associé de façon classique à un décodeur colonnes DCDX et à un décodeur lignes DCDY.

Comme on l'a vu précédemment, le dispositif de mémoire utilise au moins deux structures intégrées du type de celles illustrées sur la figure 15, c'est-à-dire comportant un transistor MOS TR et un condensateur C ayant une première électrode ELC1 formée par la région de grille G du transistor TR et une deuxième électrode ELC2 séparée de la première électrode par un diélectrique de grille OX.

Comme on le voit sur cette figure, la deuxième électrode ELC2 est située au dessus de la première électrode ELC1 et le diélectrique de grille OX se situe au dessus du diélectrique de grille du transistor TR, qui sépare la grille de ce transistor de la région de canal.

Cette structure comporte également une première région de contact RGC1 électriquement conductrice au contact de la région de grille G et une deuxième région de contact électriquement conductrice RGC2 au contact de la deuxième électrode. Ces deux régions de contact ne sont pas électriquement reliées et permettent ainsi d'appliquer des potentiels correspondants sur les deux électrodes du condensateur ainsi que sur la grille du transistor.

Une telle structure STR est particulièrement compacte et simple à réaliser. Cela étant, son application n'est pas limitée à un dispositif de mémoire tel que décrit ci-avant mais une telle structure peut être employée dans d'autres circuits électroniques comme par exemple des bascules élémentaires, des éléments de registre à décalage du type maître-esclave, des filtres (le condensateur C formé entre les deux niveaux de polysilicium étant utilisé pour la réalisation de la constante de temps RC du filtre).

## Revendications

1. Dispositif de mémoire comprenant au moins une cellule-mémoire (CEL) du type comportant une cellule-mémoire élémentaire du type SRAM (CELSR) possédant deux inverseurs couplés de façon croisée et au moins une cellule-mémoire élémentaire non volatile (CELNV) mutuellement couplées, **caractérisé en ce que** ladite au moins une cellule-mémoire élémentaire non volatile comporte au moins un transistor à grille flottante (E1), la cellule-mémoire élémentaire du type SRAM (CELSR) comporte au moins deux structures intégrées (STR) possédant chacune un transistor MOS (TR) ayant un premier diélectrique de grille (OX1) et un condensateur (C) ayant une première électrode (ELC1) formée par la région de grille (G) du transistor (TR) et une deuxième électrode (ELC2) située au dessus de la première électrode (ELC1) et séparée de la première électrode (ELC1) par un deuxième diélectrique de grille (OX12) situé au-dessus du premier diélectrique de grille, une première région de contact électriquement conductrice (RGC1) au contact de la région de grille (G) et une deuxième région de contact électriquement conductrice (RGC2) au contact de la deuxième électrode (ELC2), les deux régions de contact n'étant pas électriquement reliées, les transistors MOS (TR) des structures intégrées (STR) formant respectivement au moins deux transistors (P1, P2) des deux inverseurs, chaque deuxième électrode (ELC2) étant destinée à être reliée à un potentiel, les autres transistors de la cellule-mémoire élémentaire SRAM comportent une région de grille surmontée par une région auxiliaire située au même niveau que les deuxièmes électrodes des structures intégrées et séparée de la région de grille par le deuxième diélectrique de grille (OX12).

2. Dispositif selon la revendication 1, dans lequel lesdits deux transistors (P1, P2) des deux inverseurs sont les transistors PMOS.

3. Dispositif selon la revendication 1 ou 2, dans lequel les deux deuxièmes électrodes (ELC2) sont reliées respectivement aux sorties des deux inverseurs (SS1, SS2).

4. Dispositif selon la revendication 1 ou 2, dans lequel les deux deuxièmes électrodes (ELC2) sont destinées à être reliées à une tension d'alimentation (Vdd) ou à la masse (GND).

5. Dispositif selon l'une des revendications précédentes, dans lequel ladite au moins une cellule-mémoire comprend une unique cellule-mémoire élémentaire non volatile (E1) connectée entre une borne d'alimentation (BAL) et la cellule-mémoire élémentaire du type SRAM (CELSR), le transistor à grille flottante (E1) de la cellule-mémoire élémentaire non volatile étant commandable de façon à être bloqué lors d'une programmation dans la cellule-mémoire élémentaire non volatile (E1), d'une donnée stockée dans la cellule-mémoire élémentaire du type SRAM (CELSR).

6. Dispositif selon l'une des revendications précédentes, dans lequel ladite au moins une cellule-mémoire comprend deux groupes (E1, E2) comportant chacun au moins une cellule-mémoire élémentaire non volatile possédant un transistor à grille flottante, tous les transistors à grille flottante ayant leur première électrode de conduction connectée à une borne d'alimentation (BAL) et leur électrode de commande connectée à une première ligne de commande (CGL), les deuxièmes électrodes de conduction des transistors à grille flottante des cellules mémoire élémentaires non volatile des deux groupes étant respectivement connectées au moins aux sorties des deux inverseurs par l'intermédiaire d'un étage d'interconnexion commandable (N2, N4, N5, N7), les transistors à grille flottante (E1, E2) étant commandables de façon à être tous bloqués lors d'une programmation différentielle dans les deux groupes de cellules-mémoire élémentaires non volatiles, d'une donnée stockée dans la cellule-mémoire élémentaire du type SRAM.

7. Dispositif selon l'une des revendications précédentes, dans lequel le deuxième diélectrique de grille (OX12) comprend une couche de nitrure de silicium prise en sandwich entre deux couches de dioxyde de silicium.

8. Dispositif selon l'une des revendications précédentes, dans lequel chaque cellule-mémoire élémentaire non volatile est une cellule du type EEPROM.

9. Dispositif selon l'une des revendications précédentes, comprenant un plan-mémoire (PM) comportant des lignes et des colonnes de cellules mémoire.

10. Circuit intégré incorporant un dispositif de mémoire selon l'une des revendications 1 à 9.

## Patentansprüche

1. Speichervorrichtung, die wenigstens eine Speicherzelle (CEL) des Typs umfasst, der eine elementare Speicherzelle des SRAM-Typs (CELSR), die zwei über Kreuz gekoppelte Inverter besitzt, und wenigstens eine nichtflüchtige elementare Speicherzelle (CELNV) enthält, die miteinander gekoppelt sind, **dadurch gekennzeichnet, dass** die wenigstens eine nichtflüchtige elementare Speicherzelle wenigstens einen Transistor (E1) mit schwebendem Gate umfasst und die elementare Speicherzelle des SRAM-Typs (CELSR) wenigstens zwei integrierte Strukturen (STR) umfasst, die jeweils einen MOS-Transistor (TR), der ein erstes Gate-Dielektrikum (OX1) und einen Kondensator (C) mit einer durch den Gate-Bereich (G) des Transistors (TR) gebildeten ersten Elektrode (ELC1) und einer über der ersten Elektrode (ELC1) befindlichen zweiten Elektrode (ELC2), die von der ersten Elektrode (ELC1) durch ein zweites Gate-Dielektrikum (OX12) getrennt ist, das sich über dem ersten Gate-Dielektrikum befindet, aufweist, einen ersten elektrisch leitenden Kontaktbereich (RGC1) in Kontakt mit dem Gate-Bereich (G) und einen zweiten elektrisch leitenden Kontaktbereich (RGC2) in Kontakt mit der zweiten Elektrode (ELC2) besitzen, wobei die zwei Kontaktbereiche nicht elektrisch verbunden sind, wobei die MOS-Transistoren (TR) der integrierten Strukturen (STR) jeweils wenigstens zwei Transistoren (P1, P2) der zwei Inverter bilden, wobei jede zweite Elektrode (ELC2) dazu bestimmt ist, mit einem Potential verbunden zu werden, und die anderen Transistoren der elementaren SRAM-Speicherzelle einen Gate-Bereich aufweisen, der von einem zusätzlichen Bereich überlagert ist, der sich auf derselben Höhe wie die zweiten Elektroden der integrierten Strukturen befindet und von dem Gate-Bereich durch das zweite Gate-Dielektrikum (OX12) getrennt ist.

2. Vorrichtung nach Anspruch 1, wobei die zwei Transistoren (P1, P2) der zwei Inverter PMOS-Transistoren sind.

3. Vorrichtung nach Anspruch 1 oder 2, wobei die zwei zweiten Elektroden (ELC2) jeweils mit den Ausgängen der zwei Inverter (SS1, SS2) verbunden sind.

4. Vorrichtung nach Anspruch 1 oder 2, wobei die zwei zweiten Elektroden (ELC2) dazu bestimmt sind, mit einer Versorgungsspannung (Vdd) oder mit Masse (GND) verbunden zu werden.

5. Vorrichtung nach einem der vorhergehenden Ansprüche, wobei die wenigstens eine Speicherzelle eine einzige nichtflüchtige elementare Speicherzelle (E1) umfasst, die zwischen einen Versorgungsanschluss (BAL) und die elementare Speicherzelle des SRAM-Typs (CELSR) geschaltet ist, wobei der Transistor (E1) mit schwebendem Gate der nichtflüchtigen elementaren Speicherzelle in der Weise gesteuert werden kann, dass er sperrt, wenn in der nichtflüchtigen elementaren Speicherzelle (E1) Daten, die in der elementaren Speicherzelle des SRAM-Typs (CELSR) gespeichert sind, programmiert werden.

6. Vorrichtung nach einem der vorhergehenden Ansprüche, wobei die wenigstens eine Speicherzelle zwei Gruppen (E1, E2) umfasst, die jeweils wenigstens eine nichtflüchtige elementare Speicherzelle enthalten, die einen Transistor mit schwebendem Gate besitzt, wobei alle Transistoren mit schwebendem Gate mit ihrer ersten leitenden Elektrode mit einem Versorgungsanschluss (BAL) verbunden sind und mit ihrer Steuerelektrode mit einer ersten Steuerleitung (CGL) verbunden sind, wobei die zweiten leitenden Elektroden der Transistoren mit schwebendem Gate der nichtflüchtigen elementaren Speicherzellen der zwei Gruppen jeweils wenigstens mit den Ausgängen der zwei Inverter über eine steuerbare Zwischenverbindungsstufe (N2, N4, N5, N7) verbunden sind, wobei die Transistoren (E1, E2) mit schwebendem Gate in der Weise gesteuert werden können, dass sie alle sperren, wenn in den zwei Gruppen nichtflüchtiger elementarer Speicherzellen eine differentielle Programmierung von Daten, die in der elementaren Speicherzelle des SRAM-Typs gespeichert sind, erfolgt.

7. Vorrichtung nach einem der vorhergehenden Ansprüche, wobei das zweite Gate-Dielektrikum (OX12) eine Siliciumnitrid-Schicht umfasst, die zwischen zwei Siliciumdioxidschichten eingebettet ist.

8. Vorrichtung nach einem der vorhergehenden Ansprüche, wobei jede nichtflüchtige elementare Speicherzelle eine Zelle des EEPROM-Typs ist.

9. Vorrichtung nach einem der vorhergehenden Ansprüche, die eine Speicherebene (PM) umfasst, die Zeilen und Spalten von Speicherzellen enthält.

10. Integrierte Schaltung, die eine Speichervorrichtung nach einem der Ansprüche 1 bis 9 enthält.

## Claims

1. Memory device comprising at least one memory cell (CEL) of the type comprising an SRAM elementary memory cell (CELSR) possessing two cross-coupled inverters and at least one nonvolatile elementary memory cell (CELNV), said cells being coupled together, **characterised in that** said at least one nonvolatile elementary memory cell comprises at least one floating-gate transistor (E1) and the SRAM elementary memory cell (CELSR) comprises at least two integrated structures (STR) each possessing an MOS transistor (TR) having a first gate dielectric (OX1) and a capacitor (C) having a first electrode (ELC1) formed by the gate region (G) of the transistor (TR) and a second electrode (ELC2) located above the first electrode (ELC1) and separated from the first electrode (ELC1) by a second gate dielectric (OX12) located above the first gate dielectric, a first electrically conductive contact region (RGC1) making contact with the gate region (G) and a second electrically conductive contact region (RGC2) making contact with the second electrode (ELC2), the two contact regions not being electrically connected, the MOS transistors (TR) of the integrated structures (STR) respectively forming at least two transistors (P1, P2) of the two inverters, each second electrode (ELC2) being intended to be connected to a potential, the other transistors of the SRAM elementary memory cell comprise a gate region surmounted by an auxiliary region located in the same level as the second electrodes of the integrated structures and separated from the gate region by the second gate dielectric (OX12).

2. Device according to Claim 1, in which said two transistors (P1, P2) of the two inverters are pMOS transistors.

3. Device according to either of Claims 1 and 2, in which the two second electrodes (ELC2) are respectively connected to the outputs of the two inverters (SS1, SS2).

4. Device according to either of Claims 1 and 2, in which the two second electrodes (ELC2) are intended to be connected to a supply voltage (Vdd) or to ground (GND).

5. Device according to one of the preceding claims, in which said at least one memory cell comprises a single nonvolatile elementary memory cell (E1) connected between a power supply terminal (BAL) and the SRAM elementary memory cell (CELSR), the floating-gate transistor (E1) of the nonvolatile elementary memory cell being controllable so that it is turned off during an operation for programming a datum stored in the SRAM elementary memory cell (CELSR) into the nonvolatile elementary memory cell (E1).

6. Device according to one of the preceding claims, in which said at least one memory cell comprises two groups (E1, E2) each comprising at least one nonvolatile elementary memory cell possessing a floating-gate transistor, all the floating-gate transistors having their first conduction electrode connected to a power supply terminal (BAL) and their control electrode connected to a first control line (CGL), the second conduction electrodes of the floating-gate transistors of the nonvolatile elementary memory cells of the two groups being connected to at least the outputs of the two inverters, respectively, by way of a controllable interconnect stage (N2, N4, N5, N7), the floating-gate transistors (E1, E2) being controllable so that they are all turned off during a differential operation for programming a datum stored in the SRAM elementary memory cell into the two groups of nonvolatile elementary memory cells.

7. Device according to one of the preceding claims, in which the second gate dielectric (OX12) comprises a silicon nitride layer sandwiched between two silicon dioxide layers.

8. Device according to one of the preceding claims, in which each nonvolatile elementary memory cell is an EEPROM cell.

9. Device according to one of the preceding claims, comprising a memory plane (PM) containing rows and columns of memory cells.

10. Integrated circuit incorporating a memory device according to one of Claims 1 to 9.
